# EUROPÄISCHE PATENTSCHRIFT

(11) **EP 3 714 246 B1**
(45) Veröffentlichungstag und Bekanntmachung des Hinweises auf die Patenterteilung: **19.04.2023**
(21) Anmeldenummer: 18795446.6
(22) Anmeldetag: 24.10.2018
(51) Int. Cl.: G01L 19/14, G01L 19/04, B81B 7/00

(54) **DRUCKMESSEINRICHTUNG**
PRESSURE MEASURING DEVICE
DISPOSITIF DE MESURE DE PRESSION

(30) Priorität: 23.11.2017 DE 102017127704
(43) Veröffentlichungstag der Anmeldung: 30.09.2020
(73) Patentinhaber: Endress+Hauser SE+Co. KG, 79689 Maulburg (DE)
(72) Erfinder: ZIERMANN, Rene, 14532 Kleinmachnow (DE); SIXTENSSON, Daniel, 14469 Potsdam (DE); MÜLLER, Dennis, 14550 Groß Kreutz OT (DE)
(74) Vertreter: Laufer, Michael
(86) Internationale Anmeldenummer: PCT/EP2018/079081
(87) Internationale Veröffentlichungsnummer: WO 2019/101455

(56) Entgegenhaltungen:
- WO-A1-2018/033348
- DE-A1-102014 119 396
- DE-A1-102015 117 736
- JP-A- H09 325 082
- US-A1- 2002 185 715

## Beschreibung

Die Erfindung betrifft eine Druckmesseinrichtung mit einem Träger, einem auf dem Träger angeordneten Stützkörper, einem auf dem Stützkörper angeordneten Drucksensor, einer den Stützkörper mit dem Drucksensor verbindenden, ein Fügematerial umfassenden ersten Fügung und einer den Stützkörper mit dem Träger verbindenden, ein Fügematerial umfassenden zweiten Fügung.

Druckmesseinrichtungen dienen zur messtechnischen Erfassung von Drücken, insb. von Absolutdrücken, Relativdrücken und Differenzdrücken, und werden in der industriellen Messtechnik verwendet.

In der Druckmesstechnik werden häufig so genannte Halbleiter-Drucksensoren eingesetzt. Halbleiter-Sensoren werden heute regelmäßig auf Siliziumbasis, z.B. unter Verwendung von Silicon-on-Insulator (SOI) Technologie hergestellt. Sie sind z.B. als Drucksensor-Chips ausgebildet, die typischer Weise einen Grundkörper und eine auf dem Grundkörper angeordnete Messmembran aufweisen.

Diese Drucksensoren sind sehr empfindlich und werden deshalb in ein in der Regel metallisches Gehäuse eingesetzt und über vorgeschaltete mit einer Druck übertragenden Flüssigkeit gefüllte Druckmittler mit dem zu messenden Druck beaufschlagt. Gehäuse und Drucksensor bestehen somit aus Materialien, die sehr unterschiedliche thermische Ausdehnungskoeffizienten aufweisen. Aufgrund der für die Sensormontage erforderlichen mechanischen Verbindung zwischen Gehäuse und Drucksensor können daher thermomechanische Spannungen auftreten, die sich auf das Übertragungsverhalten der Messmembran auswirken und damit die erzielbare Messgenauigkeit und deren Reproduzierbarkeit verschlechtern. Dies gilt insb. für eine temperaturabhängige Hysterese der Messergebnisse.

Zur Reduktion temperaturabhängiger auf den Drucksensor einwirkender Spannungen ist in der DE 10 2007 052 364 A1 beschrieben, den Drucksensor-Chip auf einer keramischen Zwischenschicht anzuordnen, die einen an den thermischen Ausdehnungskoeffizienten des Halbleitermaterials des Drucksensors angepassten thermischen Ausdehnungskoeffizienten aufweist. Die Zwischenschicht ist über eine mit einem elastischen Kleber ausgeführte Klebung unmittelbar auf einen metallischen Träger des Gehäuse aufgeklebt. Als Material für den Träger ist Kovar angegeben. Kovar weist einen thermischen Ausdehnungskoeffizienten von 6 ppm/K auf und liegt damit deutlich näher am thermischen Ausdehnungskoeffizienten von für Drucksensoren verwendetem Silizium von 2, 6 ppm/K als gängigere und deutlich kostengünstigere Gehäusematerialien, wie z.B. Edelstahl mit einen thermischen Ausdehnungskoeffizienten von 16 ppm/K.

Bei den beschriebenen Druckmesseinrichtungen weist die keramische Zwischenschicht eine Grundfläche auf, die größer als die Grundfläche des darauf angeordneten Drucksensors ist. Letzteres hat zur Folge, dass trotz des vergleichsweise gut angepassten thermischen Ausdehnungskoeffizienten der Zwischenschicht entstehende thermomechanische Spannungen über die gesamte Grundfläche des Drucksensors auf den Drucksensor einwirken.

Als Alternative hierzu sind aus dem Stand der Technik hierzu komplementäre Lösungsansätze bekannt, bei denen eine Reduktion temperaturabhängiger auf den Drucksensor einwirkender Spannungen dadurch erzielt wird, dass der Drucksensor auf einem frei stehenden Ende eines Sockels angeordnet wird, dessen Grundfläche deutlich kleiner als die Grundfläche des darauf montierten Drucksensors ist.

So ist z.B. in der DE 10 2014 119396 A1 eine Druckmesseinrichtung mit einem Träger, einem auf dem Träger angeordneten Sockel, einem auf dem Sockel angeordneten Drucksensor, einer den Sockel mit dem Drucksensor verbindenden ersten Klebung und einer den Sockel mit dem Träger verbindenden zweiten Klebung beschrieben. Bei dieser Druckmesseinrichtung ist der Sockel als separates stab- oder rohrförmiges Bauteil ausgebildet, dessen Grundfläche kleiner als die Grundfläche des darauf montierten Drucksensors ist, und das in eine im Träger vorgesehene Ausnehmung eingeklebt ist.

Je kleiner die Grundfläche des stab- oder rohrförmigen Sockels ist, umso schwieriger ist es jedoch, den Kleber in ausreichend genauer Dosierung in die entsprechend kleine Ausnehmung einzubringen. Darüber hinaus erfordert die präzise Ausrichtung stab- oder rohrförmiger Sockel sowohl beim Einsetzen in die Ausnehmung, als auch während der Ausführung der Klebung umso mehr Sorgfalt, je kleiner die Grundfläche des Sockels im Verhältnis zu dessen Länge ist.

Diesem Problem kann z.B. auf die in der DE 10 2015 11 77 37 A1 beschriebene Weise dadurch begegnet werden, dass der Drucksensor auf einem speziell geformten Sockel montiert wird. Dieser Sockel umfasst eine auf dem Träger montierte Basis mit vergleichsweise großer Grundfläche, an die ein Fortsatz mit deutlich geringerer Grundfläche anschließt, auf dem der Drucksensor angeordnet wird. Dabei kann die Basis z.B. auf deren dem Träger zugewandten Stirnseite eine außenseitlich umlaufende Aussparung aufweisen,
die überschüssigen Kleber aufnimmt.

Darüber hinaus ist in der DE 10 2016 107856 A1 beschrieben, die thermomechanische Kopplung zwischen einem Stützkörper und einem mittels einer Fügung auf dem Stützkörper montierten Drucksensor dadurch zu reduzieren, dass ein unmittelbar an die Fügung angrenzender Schichtbereich des Stützkörper eine dreidimensionale Oberflächentopographie aufweist, die derart ausgebildet ist, dass die dem Drucksensor zugewandte Fügefläche des Schichtbereichs über den Schichtbereich verteilt angeordnete in einer Ebene liegende Teilflächen umfasst, deren durch die Summe der Teilflächen gebildete Gesamtfläche kleiner als die Grundfläche der Fügung ist. Die Teilflächen können beispielsweise durch in den Schichtbereich mittels Laserbestrahlung oder mittels eines Ätzverfahrens eingebrachte Gräben voneinander getrennt sein, die eine Grabentiefe von 300 µm bis 700 µm und eine Grabenbreite von 10 µm bis 100 µm aufweisen.

Beide Lösungen weisen jedoch den Nachteil auf, dass die Sockel bzw. die Stützkörper als Einzelteile hergestellte Komponenten sind, die eine vergleichsweise komplizierte Formgebung aufweisen und dementsprechend aufwendig, zeitintensiv und teuer in der Herstellung sind.

Aus dem Stand der Technik ist ferner die US 2002/185715 A1 bekannt geworden, die ein Verfahren und eine Struktur zur Isolierung eines Chips von thermisch induzierten oder druckinduzierten Differentialspannungen zwischen dem Chip und einem Gehäuse offenbart.

Es ist eine Aufgabe der Erfindung eine Druckmesseinrichtung mit einem vor thermomechanischen Spannungen geschützten Drucksensor anzugeben, die kostengünstiger hergestellt werden kann.

Hierzu umfasst die Erfindung eine Druckmesseinrichtung, mit
einem Träger,
einem auf dem Träger angeordneten Stützkörper,
einem auf dem Stützkörper angeordneten Drucksensor,
einer den Stützkörper mit dem Drucksensor verbindenden, ein Fügematerial umfassenden ersten Fügung, und
einer den Stützkörper mit dem Träger verbindenden, ein Fügematerial umfassenden zweiten Fügung,
dadurch gekennzeichnet, dass der Stützkörper auf dessen dem Drucksensor zugewandten Stirnseite einen ersten Graben aufweist,
der derart ausgebildet ist, dass
der erste Graben eine dem Drucksensor zugewandten Fügefläche des Stützkörpers (3) außenseitlich, allseitig umgibt,
die Fügefläche des Stützkörpers und eine Grundfläche der ersten Fügung im Wesentlichen gleich groß und echt kleiner als eine der ersten Fügung zugewandte Grundfläche des Drucksensors sind, und
der erste Graben eine Breite aufweist, die größer gleich einer Mindestbreite von 150 µm bis 1 mm ist, und
der erste Graben eine Tiefe (aufweist, die größer gleich einer Mindesttiefe von 0,3 mm bis 2 mm ist, und
dass die auf der dem Träger zugewandten Stirnseite des Stützkörpers angeordnete Fügefläche größer gleich der auf der dem Drucksensor zugewandten Stirnseite des Stützkörpers angeordneten Fügefläche ist.

Die Erfindung bietet den Vorteil, dass der Drucksensor durch die vergleichsweise kleine, durch den ersten Graben außenseitlich begrenzte Grundfläche der ersten Fügung vor darauf übertragbaren thermomechanischen Spannungen geschützt ist.

Zugleich bietet sie den Vorteil, dass der Stützkörper aufgrund der durch den Graben sichergestellten Begrenzung der Grundfläche der ersten Fügung auf die Größe der von dem Graben umgebenen Fügefläche insgesamt eine Grundfläche aufweisen kann, die deutlich größer als die Grundfläche der ersten Fügung ist.

Zusätzlich bietet der Graben den Vorteil, dass er während des zur Erzeugung der ersten Fügung eingesetzten Fügeverfahrens ggfs. aus einem zwischen der Fügefläche des Stützkörpers und einer dieser gegenüberliegenden Oberfläche des Drucksensors bestehenden Spalt außenseitlich austretendes, überschüssiges Fügematerial aufnimmt.

Der im Vergleich zu im Stand der Technik verwendeten Sockeln große, eine vergleichsweise einfache Formgebung aufweisende Stützkörper bietet den Vorteil, dass er auf einfache, kostengünstige Weise hergestellt und aufgrund seiner Größe und Form sehr viel einfacher auf dem Träger montiert werden kann, als lange Sockel mit geringer Grundfläche.

Erste Weiterbildungen zeichnen sich dadurch aus, dass
ein zwischen einer den ersten Graben außenseitlich umgebenden Oberfläche des Stützkörpers und der dieser gegenüberliegenden Oberfläche des Drucksensors angeordneter Zwischenraum einen Hohlraum bildet, der frei von Fügematerial ist,
dass der Stützkörper eine Grundfläche aufweist, die größer gleich einer Grundfläche einer der ersten Fügung zugewandten Stirnseite des Drucksensors ist, und/oder
die erste Fügung und/oder die zweite Fügung jeweils als Glaslötung, als Weichlötung oder als Klebung ausgebildet sind.

Zweite Weiterbildungen zeichnen sich dadurch aus, dass
der Drucksensor eine Grundfläche in der Größenordnung von 1 mm² bis 50 mm² aufweist,
die dem Drucksensor zugewandte Fügefläche des Stützkörper eine Größe von 0,2 mm² bis 20 mm² aufweist,
der Träger aus einem Metall oder aus einem Edelstahl besteht,
der Stützkörpers aus einem Metall, aus einem Edelstahl, aus Kovar, aus Invar, aus einer Keramik, aus Aluminiumoxid (Al₂O₃), aus Siliziumcarbid (SiC), aus Siliziumnitrid (Si₃N₄), aus Aluminiumnitrid (AIN), aus Glas, aus Borosilikatglas oder aus einem Silizium umfassende Material besteht,
der Stützkörper als ein im Wesentlichen scheibenförmiger Körper mit kreisförmiger, rechteckiger oder quadratischer Grundfläche ausgebildet ist, und/oder
der Stützkörper als freistehendes Element unmittelbar auf dem Träger angeordnet ist oder als freistehendes Element in eine Ausnehmung im Träger eingesetzt ist, und/oder der Stützkörper eine Bauhöhe von größer gleich 1 mm aufweist, wobei die Bauhöhe zugleich größer gleich einem zweifachen der Tiefe des ersten Grabens ist.

Eine dritte Weiterbildung zeichnet sich dadurch aus, dass
der Stützkörper auf dessen dem Träger zugewandten Stirnseite einen zweiten Graben aufweist, der eine dem Träger zugewandten Fügefläche des Stützkörpers außenseitlich, allseitig umgibt,
die zweite Fügung eine Grundfläche aufweist, die im Wesentlichen gleich der von dem zweiten Graben umgebenen Fügefläche ist,
der zweite Graben eine Breite aufweist, die größer gleich einer Mindestbreite von 150 µm bis 1 mm ist, und
der zweite Graben eine Tiefe aufweist, die größer gleich einer Mindesttiefe von 0,3 mm bis 2 mm ist.

Eine vierte Weiterbildung zeichnet sich dadurch aus, dass
der Stützkörper auf dessen dem Träger zugewandten Stirnseite eine außenseitlich umlaufende, zu einer äußeren Mantelfläche und zu der dem Träger zugewandten Stirnseite des Stützkörpers hin offene Aussparung aufweist,
die die dem Träger zugewandte Fügefläche des Stützkörpers außenseitlich allseitig umgibt, und
deren Höhe größer gleich einer Mindesthöhe von 0,3 mm bis 2 mm ist, und/oder deren Breite größer gleich einer Mindestbreite von 150 µm bis 1 mm ist.

Eine fünfte Weiterbildung zeichnet sich dadurch aus, dass der auf der dem Drucksensor zugewandten Stirnseite des Stützkörpers angeordnete Graben und/oder der auf der dem Träger zugewandten Stirnseite des Stützkörpers angeordnete zweite Graben jeweils als ein zu einem Ring geschlossener Graben ausgebildet ist.

Eine bevorzugte Ausgestaltung zeichnet sich dadurch aus, dass die erste Fügung und/oder die zweite Fügung jeweils als Klebung ausgebildet ist.

Eine siebte Weiterbildung zeichnet sich dadurch aus, dass
der Stützkörper auf dessen dem Drucksensor zugewandten Stirnseite vier in den Stützkörper eingebrachte, jeweils in gerader Linie von einer Außenseite des Stützkörper zu einer dieser Außenseite gegenüberliegenden Außenseite des Stützkörpers verlaufende Gräben aufweist, die jeweils ein parallel zu einer der Außenkanten der Fügefläche verlaufendes, unmittelbar an die jeweilige Außenkante angrenzendes Grabensegment aufweisen und derart angeordnet sind, dass die vier an die Außenkanten der Fügefläche angrenzenden Grabensegmente den die Fügefläche außenseitlich allseitig umgebenden ersten Graben bilden, und/oder
der Stützkörper auf dessen dem Träger zugewandten Stirnseite vier in den Stützkörper eingebrachte, jeweils in gerader Linie von einer Außenseite des Stützkörper zu einer dieser Außenseite gegenüberliegenden Außenseite des Stützkörpers verlaufende Gräben aufweist, die jeweils ein parallel zu einer der Außenkanten der Fügefläche verlaufendes, unmittelbar an die jeweilige Außenkante angrenzendes Grabensegment aufweisen und derart angeordnet sind, dass die vier an die Außenkanten der Fügefläche angrenzenden Grabensegmente den die Fügefläche außenseitlich allseitig umgebenden zweiten Graben bilden.

Darüber hinaus umfasst die Erfindung ein Verfahren zur Herstellung von erfindungsgemäßen Druckmesseinrichtungen, das sich dadurch auszeichnet, dass
deren Träger, deren Stützkörper und deren Drucksensor vorgefertigt werden,
wobei mehrere Stützkörper parallel zueinander aus einem als Folie oder als Scheibe vorliegenden Ausgangswerkstoff der Stützkörper gefertigt werden, indem die ersten Gräben und/oder die Aussparungen in den einzelnen Stützkörpern jeweils mittels eines Bearbeitungsverfahrens erzeugt und die Stützkörper anschließend mittels eines Vereinzelungsverfahrens vereinzelt werden, und
aus den vorgefertigten Komponenten Druckmesseinrichtungen gefertigt werden, indem deren Stützkörper mittels eines mittels eines Fügematerials ausgeführten Fügeverfahrens auf deren Träger und deren Drucksensor mittels eines mittels eines Fügematerials ausgeführten Fügeverfahrens auf deren Stützkörper montiert wird, wobei die Fügungen derartig ausgeführt werden, dass die auf dem Träger zugewandten Stirnseite des Stützkörpers angeordnete Fügefläche größer gleich der auf dem Drucksensor zugewandten Stirnseite des Stützkörpers angeordneten Fügefläche wird.

Eine Weiterbildung des Verfahrens zeichnet sich dadurch aus, dass mindestens ein Bearbeitungsverfahren und/oder das Vereinzelungsverfahrens ein mittels eines mit Laser oder Ultraschall arbeitenden Schneidwerkzeugs oder mittels einer Säge ausgeführtes Verfahren ist.

Eine Weiterbildung des Verfahrens zur Herstellung von Druckmesseinrichtungen gemäß der siebten Weiterbildung zeichnet sich dadurch aus, dass die die auf der dem Drucksensor zugewandten Stirnseite der Stützkörper angeordneten ersten Gräben bildenden Grabensegmente enthaltenden Gräben und/oder die die auf der dem Träger zugewandten Stirnseite der Stützkörper angeordneten zweiten Gräben bildenden Grabensegmente enthaltenden Gräben jeweils durch mittels einer Säge in den Ausgangswerkstoff eingebrachte Sägeschnitte erzeugt werden, die sich von einer Außenseite des Ausgangswerkstoffs bis zu einer dieser gegenüberliegenden Außenseite des Ausgangswerkstoffs erstrecken.

Eine Weiterbildung des Verfahrens zur Herstellung von Druckmesseinrichtungen gemäß der vierten Weiterbildung zeichnet sich dadurch aus, dass die Aussparungen durch mittels einer Säge in den Ausgangswerkstoff eingebrachte Sägeschnitte erzeugt werden, die sich von einer Außenseite des Ausgangswerkstoffs bis zu einer dieser gegenüberliegenden Außenseite des Ausgangswerkstoffs erstrecken.

Eine weitere Weiterbildung des Verfahrens zeichnet sich dadurch aus, dass jede Druckmesseinrichtung jeweils derart hergestellt wird, dass während des zur Erzeugung der ersten Fügung eingesetzten Fügeverfahrens ggfs. aus einem zwischen der Fügefläche des Stützkörpers und einer dieser gegenüberliegenden Oberfläche des Drucksensors bestehenden Spalt außenseitlich austretendes, überschüssiges Fügematerial von dem die Fügefläche umgebenden ersten Graben aufgenommen wird.

Eine Weiterbildung des Verfahrens zur Herstellung von Druckmesseinrichtungen, deren Stützkörper auf deren dem Träger zugewandten Stirnseite den zweiten Graben oder die Aussparung aufweisen, zeichnet sich dadurch aus, dass jede Druckmesseinrichtung jeweils derart hergestellt wird, dass während des zur Erzeugung der zweiten Fügung eingesetzten Fügeverfahrens ggfs. aus einem zwischen der Fügefläche des Stützkörpers und einer dieser gegenüberliegenden Oberfläche des Trägers bestehenden Spalt außenseitlich austretendes, überschüssiges Fügematerial von dem die Fügefläche umgebenden zweiten Graben bzw. der die Fügefläche umgebende Aussparung aufgenommen wird.

Die Erfindung und deren Vorteile werden nun anhand der Figuren der Zeichnung, in denen drei Ausführungsbeispiele dargestellt sind, näher erläutert. Gleiche Elemente sind in den Figuren mit den gleichen Bezugszeichen versehen. Um Bauteile sehr unterschiedlicher Abmessungen darstellen zu können wurde in den Figuren eine nicht immer maßstabsgetreue Darstellung gewählt.
- Fig. 1, 3 und 5 zeigen:: jeweils ein Beispiel einer Druckmesseinrichtung;
- Fig. 2 zeigt:: den Stützkörper der Druckmesseinrichtung von Fig. 1;
- Fig. 4 zeigt:: den Stützkörper der Druckmesseinrichtung von Fig. 3;
- Fig. 6 zeigt:: den Stützkörper der Druckmesseinrichtung von Fig. 5; und
- Fig. 7 zeigt:: eine Draufsicht auf eine dem Drucksensor zugewandte Stirnseite eines der Stützkörper von Fig. 1 bis 6.

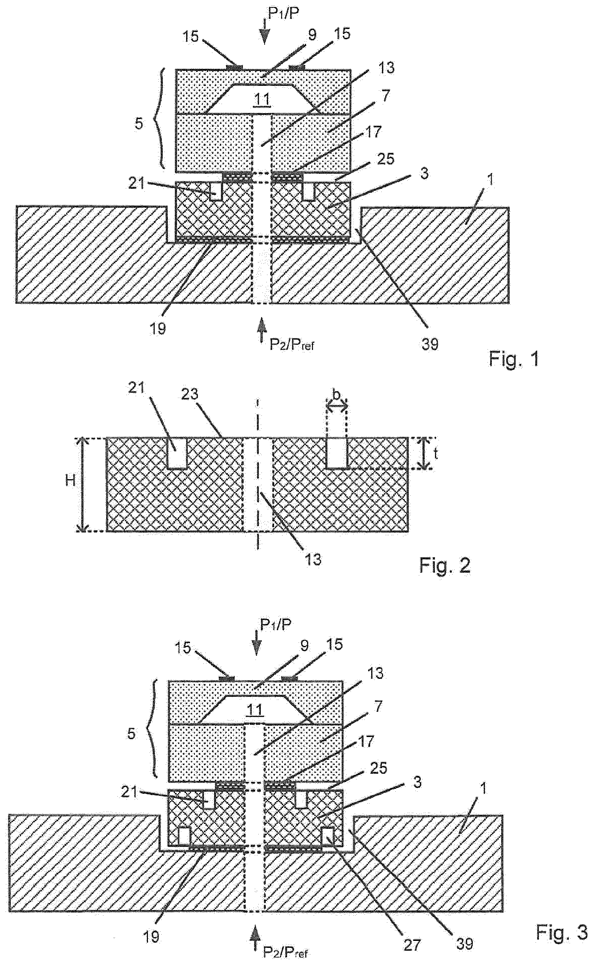

Fig. 1 zeigt ein Beispiel einer erfindungsgemäßen Druckmesseinrichtung. Die Druckmesseinrichtung umfasst einen Träger 1, einen auf dem Träger 1 angeordneten Stützkörper 3 und einen auf dem Stützkörper 3 angeordneten Drucksensor 5. Fig. 2 zeigt eine vergrößerte Darstellung des Stützkörpers 3 von Fig. 1.

Der Drucksensor 5 ist z.B. ein Halbleiter-Drucksensor, wie z.B. ein auf Siliziumbasis hergestellter Drucksensor-Chip. Dieser umfasst einen in dem dargestellten Beispiel als Membranträger ausgebildeten Grundkörper 7 und eine auf dem Grundkörper 7 angeordnete Messmembran 9, unter der eine Druckkammer 11 eingeschlossen ist. Alternativ kann anstelle des hier dargestellten Drucksensors 5 natürlich auch ein Drucksensor mit einem hiervon abweichenden Aufbau eingesetzt werden.

Die Druckmesseinrichtung kann als Differenzdruck-, als Relativdruck- oder als Absolutdruckmesseinrichtung ausgestaltet sein.

Zur Erfassung von Differenzdrücken wird eine erste Seite der Messmembran 9 mit einem ersten Druck p₁ beaufschlagt und deren zweite Seite über eine durch den Träger 1, den Stützkörper 3 und den Grundkörper 7 hindurch verlaufende, in der Druckkammer 11 mündende - in Fig. 1 gestrichelt dargestellte - Druckübertragungsleitung 13 mit einem zweiten Druck p₂ beaufschlagt. Bei dieser Ausführungsform bewirkt die auf die Messmembran 9 einwirkende Druckdifferenz zwischen dem ersten und dem zweiten Druck p₁, p₂ eine vom zu messenden Differenzdruck Δp abhängige Auslenkung der Messmembran 9.

Zur Erfassung von Relativdrücken wird die erste Seite der Messmembran 9 mit dem zu messenden Druck p beaufschlagt und der zweiten Seite der Messmembran 9 wird anstelle des zweiten Drucks p₂ ein Referenzdruck p_{ref}, z.B. ein Umgebungsdruck, zugeführt, bezogen auf den der auf die erste Seite einwirkende Druck p gemessen werden soll. Bei dieser Ausführungsform bewirkt die auf die Messmembran 9 einwirkende Druckdifferenz zwischen dem Druck p und dem Referenzdruck p_{ref} eine vom zu messenden Relativdruck abhängige Auslenkung der Messmembran 9.

Zur Erfassung von Absolutdrücken ist die unter der Messmembran 9 eingeschlossene Druckkammer 11 evakuiert. In dem Fall entfällt die Druckübertragungsleitung 13 und der auf die erste Seite der Messmembran 9 einwirkende Druck p bewirkt eine vom zu messenden Absolutdruck abhängige Auslenkung der Messmembran 9.

Die resultierende Auslenkung der Messmembran 9 wird in allen drei Fällen mittels eines elektromechanischen Wandlers erfasst und in ein elektrisches Ausgangssignal umgewandelt, das dann für eine weitere Verarbeitung und/oder Auswertung zur Verfügung steht. Als Wandler kann z.B. ein piezoresistiver Wandler eingesetzt werden, der auf oder in der Messmembran 9 angeordnete Sensorelemente 15, z.B. zu einer Widerstandsmessbrücke zusammengeschaltete piezoresistive Elemente, umfasst.

Der Stützkörper 3 ist mittels einer ein Fügematerial umfassenden ersten Fügung 17 mit dem Drucksensor 5 und mittels einer ein Fügematerial umfassenden zweiten Fügung 19 mit dem Träger 1 verbunden. Dabei können die erste Fügung 17 und/oder die zweite Fügung 19 je nach Wahl des Fügematerials jeweils z.B. als Glaslötung, als Weichlötung oder als Klebung ausgebildet sein. Vorzugsweise ist mindestens eine der beiden Fügungen 17, 19 eine Klebung. In einer besonders bevorzugten Ausführungsform sind beide Fügungen 17, 19 Klebungen. Zur Herstellung der Klebungen eignen sich insb. Kleber auf Epoxidharzbasis, thermoplastische Kleber oder Silikon-Kleber, wie zum Beispiel Silikon-Kautschuk.

Klebungen bieten den Vorteil, dass sie deutlich elastischer sind als alternativ einsetzbare Fügungen, wie zum Beispiel Glaslötungen oder Weichlötungen. Sie sind somit besser in der Lage aufgrund unterschiedlicher thermischer Ausdehnungskoeffizienten von Träger 1 und Stützkörper 3 bzw. von Stützkörper 3 und Drucksensor 5 entstehende Spannungen auszugleichen bzw. abzubauen, die andernfalls auf den Drucksensor 5, insb. dessen Messmembran 9 übertragen werden könnten. Darüber hinaus kann durch Klebungen eine große Bandbreite unterschiedlicher Werkstoffe von Träger 1 und Stützkörper 3 bzw. von Stützkörper 3 und Drucksensor 5 miteinander verbunden werden.

Unabhängig von der Wahl der zur Herstellung der Fügungen 17, 19 verwendeten Fügeverfahren besteht der Träger 1 im Hinblick auf dessen Druckfestigkeit vorzugsweise aus einem Werkstoff mit hohem Elastizitätsmodul, und im Hinblick auf dessen vergleichsweise großes Volumen vorzugsweise aus einem kostengünstigen Werkstoff. Hierzu eignen sich insb. Metalle, wie z.B. Edelstahl.

Der Werkstoff des Stützkörpers 3 kann im Hinblick auf die speziellen Anforderungen an die Druckmesseinrichtung aus einer Vielzahl unterschiedlicher Werkstoffe ausgewählt werden. Hierzu zählen Metalle, insb. Edelstahl, Kovar oder Invar, Keramiken, insb. Aluminiumoxid (Al₂O₃), Siliziumcarbid (SiC), Siliziumnitrid (Si₃N₄) oder Aluminiumnitrid (AIN), Gläser, insb. Borosilikatglas, und Silizium umfassende Materiale. Dabei sind jedoch durch die Wahl der Fügeverfahren ggfs. vorhandene Einschränkungen bei der Auswahl des Werkstoffs zu berücksichtigen.

Erfindungsgemäß weist der Stützkörper 3 auf dessen dem Drucksensor 5 zugewandten Stirnseite einen Graben 21 auf, der eine dem Drucksensor 5 zugewandten Fügefläche 23 des Stützkörpers 3 außenseitlich allseitig umgibt. Dieser Graben 21 ist derart ausgebildet, dass die Fügefläche 23 des Stützkörpers 3 und eine Grundfläche der ersten Fügung 17 im Wesentlichen gleich groß und echt kleiner als eine der ersten Fügung 17 zugewandte Grundfläche des Drucksensors 5 sind. Hierzu weist der Graben 21 eine Breite b auf, die größer gleich einer Mindestbreite von 150 µm bis 1 mm ist, und eine Tiefe t auf, die größer gleich einer Mindesttiefe von 0,3 mm bis 2 mm ist.

Durch diese Bemessung von Breite b und Tiefe t des Grabens 21 wird erreicht, dass der Graben 21 die Grundfläche der ersten Fügung 17 während des gesamten zur Herstellung der ersten Fügung 17 eingesetzten Fügeverfahrens auf die Größe der Fügefläche 23 derart begrenzt, dass ein zwischen einer den Graben 21 außenseitlich umgebenden Oberfläche des Stützkörpers 3 und der dieser gegenüberliegenden Oberfläche des Drucksensors 5 angeordneter Zwischenraum 25 einen Hohlraum bildet, der frei von Fügematerial ist.

Dabei verhindert der Graben 21, dass zur Herstellung der ersten Fügung 17 in einen zwischen der Fügefläche 23 des Stützkörpers 3 und der dieser gegenüberliegenden Oberfläche des Drucksensors 5 befindlichen Spalt eingebrachtes, während des Fügeverfahrens flüssig oder zähflüssig gewordenes Fügematerial sich bis in den Zwischenraum 25 hinein ausbreiten kann. Zugleich ist durch die Bemessung von Breite b und Tiefe t des Grabens 21 sichergestellt, dass der Graben 21 groß genug ist, um ggfs. während des Fügeverfahrens außenseitlich aus dem Spalt austretendes, überschüssiges Fügematerial aufzunehmen. Der Graben 21 bildet somit während des gesamten Fügeverfahrens eine Barriere, die von dem Fügematerial nicht überwunden werden kann.

Die durch den Graben 21 bewirkte bzw. sichergestellte Begrenzung der Grundfläche der Fügung 17 auf die Größe der von dem Graben 21 umgebenen Fügefläche 23 bietet den Vorteil, dass der Stützkörper 3 insgesamt eine Grundfläche aufweisen kann, die deutlich größer als die Fügefläche 23 ist, ohne dass sich hierdurch die Grundfläche der Fügung 17 vergrößert. Insoweit kann der Stützkörper 3 ohne Weiteres eine Grundfläche aufweisen, die größer gleich der Grundfläche der der ersten Fügung 17 zugewandten Stirnseite des Drucksensors 5 ist. Der im Vergleich zu im Stand der Technik verwendeten Sockeln große, eine vergleichsweise einfache Formgebung aufweisende Stützkörper 3 bietet den Vorteil, dass er auf einfache, kostengünstige Weise hergestellt und auf einfache, kostengünstige Weise auf dem Träger 1 montiert werden kann.

Halbleiter-Drucksensoren weisen regelmäßig eine Grundfläche auf, deren Größe je nach Messbereich und Messempfindlichkeit in der Größenordnung von 1 mm² bis 50 mm² liegt. Bei Drucksensoren 5 mit quadratische Grundfläche entspricht das einer Seitenlänge von 1 mm bis ca. 7 mm. In Verbindung mit einem Drucksensor 5 dieser Größe kann die Fügefläche 23 des Stützkörper 3 je nach Größe der Grundfläche des Drucksensors 5 beispielsweise eine Größe von 0,2 mm² bis 20 mm² aufweisen. Ist die Fügefläche 23 quadratische, so entspricht das einer Seitenlänge von 0,5 mm bis ca. 4,5 mm.

Sowohl bei der als Differenzdruckmesseinrichtung als auch bei der als Relativdruckmesseinrichtung ausgebildeten Druckmesseinrichtung reduziert sich die Fügefläche 23 um die Querschnittsfläche der durch die erste Fügung 17 hindurch verlaufenden Druckübertragungsleitung 13.

Durch die im Vergleich zur Grundfläche des Drucksensors 5 kleine Grundfläche der ersten Fügung 17 wird eine vergleichsweise hochwertige thermomechanische Entkopplung zwischen Drucksensor 5 und Stützkörper 3 erzielt. Dabei sind über die erste Fügung 17 auf den Drucksensor 5 übertragbare thermomechanische Spannungen umso geringer, je kleiner die Fügefläche 23 des Stützkörpers 3 und damit auch die Grundfläche der ersten Fügung 17 ist.

Darüber hinaus sind über die erste Fügung 17 auf den Drucksensor 5 übertragbare thermomechanische Spannungen umso geringer, je größer eine Schichtdicke der ersten Fügung 17 ist und je elastischer die erste Fügung 17 ist. Je größer die Schichtdicke der ersten Fügung 17 ist, umso größer sind natürlich auch Breite b und Tiefe t des Grabens 21 zu bemessen, um sicher zu stellen, dass der Graben 21 ggfs. aus dem Spalt austretendes, überschüssiges Fügematerial vollständig aufnehmen kann.

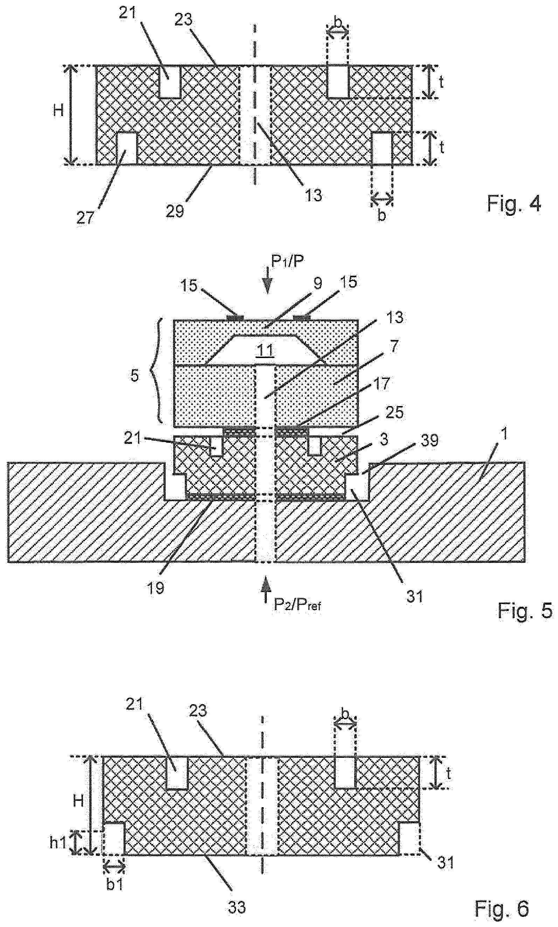

Optional kann der Stützkörper 3 auf dessen dem Träger 1 zugewandten Stirnseite einen zweiten Graben 27 aufweisen, der eine dem Träger 1 zugewandte Fügefläche 29 des Stützkörpers 3 außenseitlich allseitig umgibt. Fig. 3 zeigt ein Beispiel einer mit einem solchen Stützkörper 3 ausgestattet Druckmesseinrichtung und Fig. 4 zeigt den Stützkörper 3 von Fig. 3. Für den zweiten Graben 27 gelten die obigen Ausführungen zur Breite b und zur Tiefe t des in der dem Drucksensor 5 zugewandten Stirnseite angeordneten Grabens 21 entsprechend.

Der zweite Graben 27 bewirkt ein Begrenzung der Grundfläche der den Stützkörper 3 mit dem Träger 1 verbindenden zweiten Fügung 19 auf eine Fläche die echt kleiner als die Grundfläche des Stützkörpers 3 ist. Hierdurch wird eine Reduktion der thermomechanischen Kopplung zwischen Träger 1 und Stützkörper 3 erzielt, die wiederum eine Verbesserung des Schutzes des Drucksensors 5 vor darauf ausgeübten thermomechanischen Spannungen bewirkt.

Da die den Träger 1 mit dem Stützkörper 3 verbindende zweite Fügung 19 vom Drucksensor 5 durch die Bauhöhe H des Stützkörpers 3 beabstandet ist und somit nur in deutlich geringem Maße für auf den Drucksensor 5 ausgeübte thermomechanische Spannungen mitverantwortlich ist, kann die auf der dem Träger 1 zugewandten Stirnseite des Stützkörpers 3 angeordnete, von dem zweiten Graben 27 umgebene Fügefläche 29 ohne weiteres eine Größe, aufweisen, die größer gleich der auf der dem Drucksensor 5 zugewandten Stirnseite des Stützkörpers 3 angeordneten Fügefläche 23 ist.

Alternativ kann die Grundfläche der den Stützkörper 3 mit dem Träger 1 verbindenden zweiten Fügung 19 optional auch dadurch begrenzt werden, dass der Stützkörper 3 auf dessen dem Träger 3 zugewandten Stirnseite eine außenseitlich umlaufende, zu einer äußeren Mantelfläche und zu der dem Träger 1 zugewandten Stirnseite des Stützkörpers 3 hin offene Aussparung 31 aufweist, die die dem Träger 1 zugewandte Fügefläche 33 des Stützkörpers 3 außenseitlich allseitig umgibt. Fig. 5 zeigt ein Beispiel einer mit einem solchen Stützkörper 3 ausgestattet Druckmesseinrichtung und Fig. 6 zeigt den Stützkörper 3 von Fig. 5.

In dem Fall weist die Aussparung 31 vorzugweise eine Höhe h1 auf, die größer gleich einer Mindesthöhe von 0,3 mm bis 2 mm ist. Alternativ oder zusätzlich hierzu weist sie vorzugsweise eine Breite b1 auf, die die größer gleich einer Mindestbreite von 150 µm bis 1 mm ist.

Die in Fig. 1 bis 6 als Beispiel dargestellten Stützkörper 3 können z.B. als im Wesentlichen scheibenförmige Körper mit kreisförmiger, rechteckiger oder quadratischer Grundfläche ausgebildet sein, in deren dem Drucksensor 5 zugewandten Stirnseite der erste Graben 21 eingebracht ist.

Der erste Graben 21 kann z.B. als ein zu einem Ring geschlossener Graben 21 ausgebildet sein. So kann der erste Graben 21 z.B. als ein in der Draufsicht elliptischer, kreisförmiger, viereckiger, insb. rautenförmiger, rechteckförmiger oder quadratischer Ring ausgebildet sein, der die dementsprechend elliptische, kreisförmige, viereckige, insb. rautenförmige, rechteckförmige oder quadratische Fügefläche 23 außenseitlich allseitig umgibt.

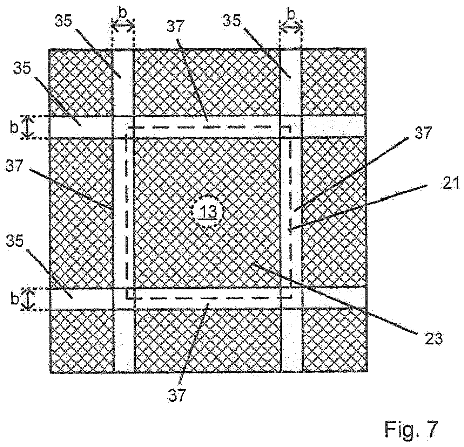

Ist die Fügefläche 23 als viereckige, vier Außenkanten aufweisende Fügefläche 23 ausgebildet, so kann der Stützkörper 3 alternativ auch auf dessen dem Drucksensor 5 zugewandten Stirnseite vier in den Stützkörper 3 eingebrachte, jeweils in gerader Linie von einer Außenseite des Stützkörper 3 zu einer dieser Außenseite gegenüberliegenden Außenseite des Stützkörpers 3 durch den gesamten Stützkörper 3 hindurch verlaufende Gräben 35 aufweisen, die jeweils ein parallel zu einer der Außenkanten der Fügefläche 23 verlaufendes unmittelbar an die jeweilige Außenkante angrenzendes Grabensegment 37 aufweisen. Fig. 7 zeigt eine Draufsicht auf die dem Drucksensor 5 zugewandte Stirnseite eines solchen Stützkörpers 3. Dort bilden die vier an die Außenkanten der Fügefläche 23 angrenzenden Grabensegmente 37 zusammen den die Fügefläche 23 außenseitlich allseitig umgebenden, in Fig. 7 durch eine gestrichelte Linie angezeigten Graben 21.

Analog können natürlich auch der ggfs. vorgesehene zweite Graben 27 und die von diesem außenseitlich umgegebene Fügefläche 29 auf diese Weise ausgebildet sein.

Alternativ oder zusätzlich hierzu kann der Stützkörper 3 als freistehendes Element auf dem Träger 1 angeordnet sein. Das bietet den Vorteil, dass auf die unterschiedlichen thermischen Ausdehnungskoeffizienten von Träger 1 und Stützkörper 3 zurück zuführende thermomechanische Spannungen über die gesamte Bauhöhe H des Trägers 1 abgebaut werden können. Insoweit weist Stützkörper 3 vorzugsweise eine Bauhöhe H von größer gleich 1 mm auf, wobei die Bauhöhe H zugleich größer gleich einem zweifachen der Tiefe t des ersten Grabens 21 ist.

Der Stützkörper 3 kann unmittelbar auf einer planaren äußeren Stirnfläche des Trägers 1 angeordnet werden. Alternativ kann der Träger 1 auf dessen dem Drucksensor 5 zugewandten Seite eine Ausnehmung 39 aufweisen, in die der Stützkörper 3 als frei stehendes Element eingesetzt ist. Diese in Fig. 1, 3 und 5 als Beispiel dargestellte Variante bietet den Vorteil einer insgesamt kleineren und kompakteren Bauform, durch die unter anderem erreicht wird, dass ein Innenraum eines - hier nicht dargestellten - Gehäuse, in das der auf dem Träger 1 montierte Drucksensor 5 eingebracht wird, deutlich kleiner sein kann. Hierdurch verringert sich das Volumen an Druck übertragender Flüssigkeit, über die die Außenseite der Messmembran 9 im Innenraum des Gehäuses mit dem zu messenden Druck p bzw. dem ersten Druck p₁ beaufschlagt wird.

Erfindungsgemäße Druckmesseinrichtungen werden vorzugsweise hergestellt, indem zunächst deren Träger 1, deren Stützkörper 3 und deren Drucksensor 5 vorgefertigt werden.

Bei der Herstellung der Stützkörper 3 wird vorzugsweise derart Verfahren, dass mehrere Stützkörper 3 parallel zueinander aus einem als Folie oder Scheibe vorliegenden Ausgangswerkstoff der Stützkörper 3 gefertigt werden.

Hierzu werden die ersten Gräben 21, sowie ggfs. auch die zweiten Gräber 27 oder die Aussparungen 31, der einzelnen Stützkörper 3 mittels eines Bearbeitungsverfahrens erzeugt und die Stützkörper 3 anschließend mittels eines Vereinzelungsverfahrens vereinzelt.

Als Bearbeitungsverfahren und/oder als Vereinzelungsverfahren eignen sich z.B. mittels eines mit Laser oder Ultraschall arbeitenden Schneidwerkzeugs ausgeführte Verfahren. Mit diesen Werkzeugen können die Gräben 21, sowie die die ggfs. zu erzeugenden zweiten Gräben 27 oder die die ggfs. zu erzeugenden Aussparungen 31 bildende Ausnehmungen mit nahezu beliebiger Formgebung erzeugt und Stützkörper 3 mit nahezu beliebiger Grundfläche aus dem Ausgangswerkstoff herausgelöst werden. Mit diesen Verfahren kann in Stützkörpern 3 für Relativ- oder Differenzdruckmesseinrichtungen zusätzlich auch die durch den jeweiligen Stützkörper 3 hindurch verlaufende Druckübertragungsleitung 13 erzeugt werden.

Zur Herstellung von ersten Gräben 21 und/oder zweiten Gräben 27, die jeweils eine viereckige Fügefläche 23 bzw. 29 umgeben, kann alternativ ein Bearbeitungsverfahren eingesetzt werden, bei dem die die Gräben 21, 27 bildenden Grabensegmente 37 enthaltenden, parallel zu den Außenkanten der Fügeflächen 23, 29 verlaufenden Gräben 35 durch mittels einer Säge in den Ausgangswerkstoff eingebrachte Sägeschnitte erzeugt werden, die sich von einer Außenseite des Ausgangswerkstoffs bis zu einer dieser gegenüberliegenden Außenseite des Ausgangswerkstoffs erstrecken. Dieses Bearbeitungsverfahren bietet im Vergleich zu alternativ einsetzbaren mittels eines mit Laser oder Ultraschall arbeitenden Schneidwerkzeugs ausgeführten Bearbeitungsverfahren den Vorteil, dass die die Fügeflächen 23, 29 umgebenden Gräben 21, 27 in einer größeren Anzahl von Stützkörpern 3 sehr viel schneller und kostengünstiger erzeugt werden können.

Analog kann auch zur Herstellung von Aussparungen 31, die jeweils eine viereckige Fügefläche 33 umgeben, ein Bearbeitungsverfahren eingesetzt werden, bei dem die Aussparungen 31 durch mittels einer Säge in den Ausgangswerkstoff eingebrachte Sägeschnitte erzeugt werden, die sich von einer Außenseite des Ausgangswerkstoffs bis zu einer dieser gegenüberliegenden Außenseite des Ausgangswerkstoffs erstrecken. Das bietet den Vorteil, dass die Aussparungen 31 in einer größeren Anzahl von Stützkörpern 3 sehr viel schneller und kostengünstiger erzeugt werden können

Nachfolgend werden die in dem Ausgangswerkstoff erzeugten Stützkörper 3 vereinzelt. Dabei muss bei der Herstellung von die Aussparungen 31 aufweisenden Stützkörpern 3 natürlich nur noch die um die Höhe h1 der Aussparung 31 reduzierte Bauhöhe H der Stützkörper 3 aus dem Ausgangswerkstoff herausgelöst werden.

Zur Vereinzelung von Stützkörpern 3 mit viereckiger Grundfläche, wie z.B. Stützkörper 3 mit rechteckiger oder quadratischer Grundfläche, kann anstelle eines mittels eines mit Laser oder Ultraschall arbeitenden Schneidwerkzeugs ausgeführten Vereinzelungsverfahrens alternativ ein Vereinzelungsverfahren eingesetzt werden, bei dem die Stützkörper 3 durch Sägen entlang deren Außenkanten vereinzelt werden. Das bietet den Vorteil, dass die Vereinzelung mehrerer Stützkörper 3 schneller und kostengünstiger ausgeführt werden kann, als das bei mittels eines mit Laser oder Ultraschall arbeitenden Schneidwerkzeugs ausgeführten Vereinzelungen der Fall ist, wo jeder Stützkörper 3 einzeln aus dem Ausgangswerkstoff herausgelöst werden muss.

Abschließend werden aus den vorgefertigten Komponenten Druckmesseinrichtungen gefertigt, indem deren Stützkörper 3 mittels eines Fügeverfahrens auf deren Träger 1 und deren Drucksensor 5 mittels eines Fügeverfahrens auf deren Stützkörper 3 montiert wird. Hierzu können aus der Mikrosystemtechnik bekannte mittels eines Fügematerials auszuführende Fügeverfahren, wie z.B. Weichlötverfahren, Glaslötverfahren oder Klebeverfahren, eingesetzt werden.

Dabei wird während des zur Erzeugung der ersten Fügung 17 ausgeführten Fügeverfahrens ggfs. aus dem Spalt zwischen Drucksensor 5 und Stützkörper 3 außenseitlich austretendes überschüssiges Fügematerial von dem die Fügefläche 23 umgebenden Graben 21 aufgenommen.

Analog wird bei Herstellung von Druckmesseinrichtungen, deren Stützkörper 3 auf dessen dem Träger 1 zugewandten Stirnseite den zweiten Graben 27 oder die Aussparung 31 aufweisen, während des zur Erzeugung der zweiten Fügung 19 ausgeführten Fügeverfahrens ggfs. aus dem zwischen der dem Träger 1 zugewandten Fügefläche 29 des Stützkörpers 3 und dem Träger 1 eingeschlossenen Spalt außenseitlich austretendes, überschüssiges Fügematerial von dem die Fügefläche 23 umgebenden Graben 27 bzw. der die Fügefläche 23 umgebende Aussparung 31 aufgenommen.

## Patentansprüche

1. Druckmesseinrichtung, mit
einem Träger (1),
einem auf dem Träger (1) angeordneten Stützkörper (3),
einem auf dem Stützkörper (3) angeordneten Drucksensor (5),
einer den Stützkörper (3) mit dem Drucksensor (5) verbindenden, ein Fügematerial umfassenden ersten Fügung (17), und
einer den Stützkörper (3) mit dem Träger (1) verbindenden, ein Fügematerial umfassenden zweiten Fügung (19),
wobei der Stützkörper (3) auf dessen dem Drucksensor (5) zugewandten Stirnseite einen ersten Graben (21) aufweist, der derart ausgebildet ist, dass
der erste Graben (21) eine dem Drucksensor (5) zugewandten Fügefläche (23) des Stützkörpers (3) außenseitlich, allseitig umgibt,
die Fügefläche (23) des Stützkörpers (3) und eine Grundfläche der ersten Fügung (17) im Wesentlichen gleich groß und echt kleiner als eine der ersten Fügung (17) zugewandte Grundfläche des Drucksensors (5) sind, und
der erste Graben (21) eine Breite (b) aufweist, die größer gleich einer Mindestbreite von 150 µm bis 1 mm ist, und
der erste Graben (21) eine Tiefe (t) aufweist, die größer gleich einer Mindesttiefe von 0,3 mm bis 2 mm ist, und
**dadurch gekennzeichnet,**
**dass** die auf der dem Träger (1) zugewandten Stirnseite des Stützkörpers (3) angeordnete Fügefläche (29, 33) größer gleich der auf der dem Drucksensor (5) zugewandten Stirnseite des Stützkörpers (3) angeordneten Fügefläche (23) ist.

2. Druckmesseinrichtung gemäß Anspruch 1, **dadurch gekennzeichnet, dass**
ein zwischen einer den ersten Graben (21) außenseitlich umgebenden Oberfläche des Stützkörpers (3) und der dieser gegenüberliegenden Oberfläche des Drucksensors (5) angeordneter Zwischenraum (25) einen Hohlraum bildet, der frei von Fügematerial ist,
dass der Stützkörper (3) eine Grundfläche aufweist, die größer gleich einer Grundfläche einer der ersten Fügung (17) zugewandten Stirnseite des Drucksensors (5) ist, und/oder
die erste Fügung (17) und/oder die zweite Fügung (19) jeweils als Glaslötung, als Weichlötung oder als Klebung ausgebildet sind.

3. Druckmesseinrichtung gemäß Anspruch 1 bis 2, **dadurch gekennzeichnet, dass**
der Drucksensor (5) eine Grundfläche in der Größenordnung von 1 mm² bis 50 mm² aufweist,
die dem Drucksensor (5) zugewandte Fügefläche (23) des Stützkörper (3) eine Größe von 0,2 mm² bis 20 mm² aufweist,
der Träger (1) aus einem Metall oder aus einem Edelstahl besteht,
der Stützkörpers (3) aus einem Metall, aus einem Edelstahl, aus Kovar, aus Invar, aus einer Keramik, aus Aluminiumoxid (Al₂O₃), aus Siliziumcarbid (SiC), aus Siliziumnitrid (Si₃N₄), aus Aluminiumnitrid (AIN), aus Glas, aus Borosilikatglas oder aus einem Silizium umfassenden Material besteht,
der Stützkörper (3) als ein im Wesentlichen scheibenförmiger Körper mit kreisförmiger, rechteckiger oder quadratischer Grundfläche ausgebildet ist, und/oder
der Stützkörper (3) als freistehendes Element unmittelbar auf dem Träger (1) angeordnet ist oder als freistehendes Element in eine Ausnehmung (39) im Träger (1) eingesetzt ist, und/oder der Stützkörper (3) eine Bauhöhe (H) von größer gleich 1 mm aufweist, wobei die Bauhöhe (H) zugleich größer gleich einem zweifachen der Tiefe (t) des ersten Grabens (21) ist.

4. Druckmesseinrichtung gemäß Anspruch 1 bis 3, **dadurch gekennzeichnet, dass**
der Stützkörper (3) auf dessen dem Träger (1) zugewandten Stirnseite einen zweiten Graben (27) aufweist, der eine dem Träger (1) zugewandten Fügefläche (29) des Stützkörpers (3) außenseitlich, allseitig umgibt,
die zweite Fügung (19) eine Grundfläche aufweist, die im Wesentlichen gleich der von dem zweiten Graben (27) umgebenen Fügefläche (29) ist,
der zweite Graben (27) eine Breite (b) aufweist, die größer gleich einer Mindestbreite von 150 µm bis 1 mm ist, und
der zweite Graben (27) eine Tiefe (t) aufweist, die größer gleich einer Mindesttiefe von 0,3 mm bis 2 mm ist.

5. Druckmesseinrichtung gemäß Anspruch 1 bis 3, **dadurch gekennzeichnet, dass** der Stützkörper (3) auf dessen dem Träger (1) zugewandten Stirnseite eine außenseitlich umlaufende, zu einer äußeren Mantelfläche und zu der dem Träger (1) zugewandten Stirnseite des Stützkörpers (3) hin offene Aussparung (31) aufweist,
die die dem Träger (1) zugewandte Fügefläche (33) des Stützkörpers (3) außenseitlich allseitig umgibt, und
deren Höhe (h1) größer gleich einer Mindesthöhe von 0,3 mm bis 2 mm ist, und/oder deren Breite (b1) größer gleich einer Mindestbreite von 150 µm bis 1 mm ist.

6. Druckmesseinrichtung gemäß Anspruch 1 bis 5, **dadurch gekennzeichnet, dass** der auf der dem Drucksensor (5) zugewandten Stirnseite des Stützkörpers (3) angeordnete Graben (21) und/oder der auf der dem Träger (1) zugewandten Stirnseite des Stützkörpers (3) angeordnete zweite Graben (27) jeweils als ein zu einem Ring geschlossener Graben (21, 27) ausgebildet ist.

7. Druckmesseinrichtung gemäß Anspruch 1 bis 6, **dadurch gekennzeichnet, dass** die erste Fügung (17) und/oder die zweite Fügung (19) jeweils als Klebung ausgebildet ist.

8. Druckmesseinrichtung gemäß Anspruch 1 bis 7, **dadurch gekennzeichnet, dass**
der Stützkörper (3) auf dessen dem Drucksensor (5) zugewandten Stirnseite vier in den Stützkörper (3) eingebrachte, jeweils in gerader Linie von einer Außenseite des Stützkörper (3) zu einer dieser Außenseite gegenüberliegenden Außenseite des Stützkörpers (3) verlaufende Gräben (35) aufweist, die jeweils ein parallel zu einer der Außenkanten der Fügefläche (23) verlaufendes, unmittelbar an die jeweilige Außenkante angrenzendes Grabensegment (37) aufweisen und derart angeordnet sind, dass die vier an die Außenkanten der Fügefläche (23) angrenzenden Grabensegmente (37) den die Fügefläche (23) außenseitlich allseitig umgebenden ersten Graben (21) bilden, und/oder
der Stützkörper (3) auf dessen dem Träger (1) zugewandten Stirnseite vier in den Stützkörper (3) eingebrachte, jeweils in gerader Linie von einer Außenseite des Stützkörper (3) zu einer dieser Außenseite gegenüberliegenden Außenseite des Stützkörpers (3) verlaufende Gräben (35) aufweist, die jeweils ein parallel zu einer der Außenkanten der Fügefläche (29) verlaufendes, unmittelbar an die jeweilige Außenkante angrenzendes Grabensegment (37) aufweisen und derart angeordnet sind, dass die vier an die Außenkanten der Fügefläche (29) angrenzenden Grabensegmente (37) den die Fügefläche (29) außenseitlich allseitig umgebenden zweiten Graben (27) bilden.

9. Verfahren zur Herstellung von Druckmesseinrichtungen gemäß Anspruch 1 bis 8, **dadurch gekennzeichnet, dass**
deren Träger (1), deren Stützkörper (3) und deren Drucksensor (5) vorgefertigt werden,
wobei mehrere Stützkörper (3) parallel zueinander aus einem als Folie oder als Scheibe vorliegenden Ausgangswerkstoff der Stützkörper (3) gefertigt werden, indem die ersten Gräben (21) und/oder die Aussparungen (31) in den einzelnen Stützkörpern (3) jeweils mittels eines Bearbeitungsverfahrens erzeugt und die Stützkörper (3) anschließend mittels eines Vereinzelungsverfahrens vereinzelt werden, und
aus den vorgefertigten Komponenten Druckmesseinrichtungen gefertigt werden, indem deren Stützkörper (3) mittels eines mittels eines Fügematerials ausgeführten Fügeverfahrens auf deren Träger (1) und deren Drucksensor (5) mittels eines mittels eines Fügematerials ausgeführten Fügeverfahrens auf deren Stützkörper (3) montiert wird, wobei die Fügungen derartig ausgeführt werden, dass die auf dem Träger (1) zugewandten Stirnseite des Stützkörpers (3) angeordnete Fügefläche (29, 33) größer gleich der auf dem Drucksensor (5) zugewandten Stirnseite des Stützkörpers (3) angeordneten Fügefläche (23) wird.

10. Verfahren gemäß Anspruch 9, **dadurch gekennzeichnet, dass** mindestens ein Bearbeitungsverfahren und/oder das Vereinzelungsverfahrens ein mittels eines mit Laser oder Ultraschall arbeitenden Schneidwerkzeugs oder mittels einer Säge ausgeführtes Verfahren ist.

11. Verfahren gemäß Anspruch 9 bis 10 zur Herstellung von Druckmesseinrichtungen gemäß Anspruch 9, **dadurch gekennzeichnet, dass**
die die auf der dem Drucksensor (5) zugewandten Stirnseite der Stützkörper (3) angeordneten ersten Gräben (21) bildenden Grabensegmente (37) enthaltenden Gräben (35) und/oder die die auf der dem Träger (1) zugewandten Stirnseite der Stützkörper (3) angeordneten zweiten Gräben (27) bildenden Grabensegmente (37) enthaltenden Gräben (35) jeweils durch mittels einer Säge in den Ausgangswerkstoff eingebrachte Sägeschnitte erzeugt werden, die sich von einer Außenseite des Ausgangswerkstoffs bis zu einer dieser gegenüberliegenden Außenseite des Ausgangswerkstoffs erstrecken.

12. Verfahren gemäß Anspruch 9 bis 11 zur Herstellung von Druckmesseinrichtungen gemäß Anspruch 5, **dadurch gekennzeichnet, dass**
die Aussparungen (31) durch mittels einer Säge in den Ausgangswerkstoff eingebrachte Sägeschnitte erzeugt werden, die sich von einer Außenseite des Ausgangswerkstoffs bis zu einer dieser gegenüberliegenden Außenseite des Ausgangswerkstoffs erstrecken.

13. Verfahren gemäß Anspruch 9 bis 12, **dadurch gekennzeichnet, dass**
jede Druckmesseinrichtung jeweils derart hergestellt wird, dass während des zur Erzeugung der ersten Fügung (17) eingesetzten Fügeverfahrens ggfs. aus einem zwischen der Fügefläche (23) des Stützkörpers (3) und einer dieser gegenüberliegenden Oberfläche des Drucksensors (5) bestehenden Spalt außenseitlich austretendes, überschüssiges Fügematerial von dem die Fügefläche (23) umgebenden ersten Graben (21) aufgenommen wird.

14. Verfahren gemäß Anspruch 9 bis 13 zur Herstellung von Druckmesseinrichtungen, deren Stützkörper (3) auf deren dem Träger (1) zugewandten Stirnseite den zweiten Graben (27) oder die Aussparung (31) aufweisen, **dadurch gekennzeichnet, dass** jede Druckmesseinrichtung jeweils derart hergestellt wird, dass während des zur Erzeugung der zweiten Fügung (19) eingesetzten Fügeverfahrens ggfs. aus einem zwischen der Fügefläche (29) des Stützkörpers (3) und einer dieser gegenüberliegenden Oberfläche des Trägers (1) bestehenden Spalt außenseitlich austretendes, überschüssiges Fügematerial von dem die Fügefläche (29) umgebenden zweiten Graben (27) bzw. der die Fügefläche (29) umgebende Aussparung (31) aufgenommen wird.

15. Verfahren gemäß Anspruch 9 und Druckmesseinrichtung gemäß Anspruch 4, **dadurch gekennzeichnet, dass** mehrere Stützkörper (3) parallel zueinander aus einem als Folie oder als Scheibe vorliegenden Ausgangswerkstoff der Stützkörper (3) gefertigt werden, indem die ersten Gräben (21), die zweiten Gräben (27) und/oder die Aussparungen (31) in den einzelnen Stützkörpern (3) jeweils mittels des Bearbeitungsverfahrens erzeugt und die Stützkörper (3) anschließend mittels des Vereinzelungsverfahrens vereinzelt werden.

## Claims

1. Pressure measuring device, with
a support (1),
a support body (3) arranged on the support (1),
a pressure sensor (5) arranged on the support body (3),
a first joint (17) connecting the support body (3) to the pressure sensor (5) and comprising a joining material, and
a second joint (19) connecting the support body (3) to the support (1) and comprising a joining material,
wherein, on the front face facing towards the pressure sensor (5), the support body (3) has a first trench (21) which is designed in such a way that
on the outside the first trench (21) surrounds, on all sides, a joint surface (23) of the support body (3) facing towards the pressure sensor (5),
the joint surface (23) of the support body (3) and an area of the first joint (17) are essentially of the same size and genuinely smaller than an area of the pressure sensor (5) facing towards the first joint (17), and
the first trench (21) has a width (b) which is greater than or equal to a minimum width of 150 µm to 1 mm, and
the first trench (21) has a depth (t) which is greater than or equal to a minimum depth of 0.3 mm to 2 mm, and
**characterized in that**
the joint surface (29, 33) arranged on the front face of the support body (3) facing towards the support (1) is greater than or equal to the joint surface (23) arranged on the front face of the support body (3) facing towards the pressure sensor (5).

2. Pressure measuring device as claimed in Claim 1, **characterized in that**
an intermediate space (25) arranged between a surface of the support body (3) surrounding the first trench (21) on the outside and the surface of the pressure sensor (5) located opposite forms a hollow cavity that is free from joining material,
the support body (3) has an area which is greater than or equal to an area of a front face of the pressure sensor (5) facing towards the first joint (17), and/or
the first joint (17) and/or the second joint (19) are each implemented as a glass solder, a soft solder or a bond.

3. Pressure measuring device as claimed in Claims 1 to 2, **characterized in that**
the pressure sensor (5) has an area on the scale of 1 mm² to 50 mm²,
the joint surface (23) of the support body (3) facing towards the pressure sensor (5) has a size of 0.2 mm² to 20 mm²,
the support (1) is made from a metal or a stainless steel,
the support body (3) is made from a metal, a stainless steel, kovar, invar, a ceramic, aluminum oxide (Al₂O₃), silicon carbide (SiC), silicon nitride (Si₃N₄), aluminum nitride (AIN), glass, borosilicate glass or a material comprising silicon,
the support body (3) is designed as an essentially disk-shaped body with a circular, rectangular or square area, and/or
the support body (3) is arranged as an independent element directly on the support (1) or is inserted as an independent element in a recess (39) in the support (1), and/or wherein the support body (3) has a construction height (H) greater than or equal to 1 mm, wherein the construction height (H) is also greater than or equal to twice the depth (t) of the first trench (21).

4. Pressure measuring device as claimed Claim 1 to 3, **characterized in that** the support body (3) has, on its front face facing towards the support (1), a second trench (27) which, on the outside, surrounds a joint surface (29) of the support body (3) facing towards the support (1) on all sides,
wherein the second joint (19) has an area, which is essentially equal to the joint surface (29) surrounded by the second trench (27),
wherein the second trench (27) has a width (b) which is greater than or equal to a minimum width of 150 µm to 1 mm, and
wherein the second trench (27) has a depth (t) which is greater than or equal to a minimum depth of 0.3 mm to 2 mm.

5. Pressure measuring device as claimed in Claim 1 to 3, **characterized in that** the support body (3) has, on its front face facing towards the support (1), a recess (31) which is externally circumferential and open towards an external lateral surface and to the front face of the support body (3) facing towards the support (1),
wherein, on the outside, said recess surrounds, on all sides, the joint surface (33) of the support body (3) facing towards the support (1), and
wherein the height (h1) of the recess is greater than or equal to a minimum height of 0.3 mm to 2 mm, and/or wherein the width (b1) of the recess is greater than or equal to a minimum width of 150 µm to 1 mm.

6. Pressure measuring device as claimed in Claim 1 to 5, **characterized in that** the trench (21) arranged on the front face of the support body (3) facing towards the pressure sensor (5) and/or the second trench (27) arranged on the front face of the support body (3) facing towards the support (1) are each formed as a trench (21, 27) closed to form a ring.

7. Pressure measuring device as claimed in Claim 1 to 6, **characterized in that** the first joint (17) and/or the second joint (19) are each implemented as a bond.

8. Pressure measuring device as claimed in Claim 1 to 7, **characterized in that**
the support body (3) has, on its front face facing towards the pressure sensor (5), four trenches (35) implemented in the support body (3) and each extending in a straight line from an outer side of the support body (3) to an outer side of the support body (3) that is opposite said outer side, wherein said trenches each have a trench segment (37) that extends parallel to one of the outer edges of the joint surface (23) and is directly adjacent to the respective outer edge, and wherein said trenches are arranged in such a way that the four trench segments (37) adjacent to the outer edges of the joint surface (23) form the first trench (21) that surrounds the joint surface (23) on all sides on the outside, and/or
the support body (3) has, on its front face facing towards the support (1), four trenches (35) implemented in the support body (3) and each extending in a straight line from an outer side of the support body (3) to an outer side of the support body (3) that is opposite said outer side, wherein said trenches each have a trench segment (37) that extends parallel to one of the outer edges of the joint surface (29) and is directly adjacent to the respective outer edge, and wherein said trenches are arranged in such a way that the four trench segments (37) adjacent to the outer edges of the joint surface (29) form the second trench (27) that surrounds the joint surface (29) on all sides on the outside.

9. Procedure to produce pressure measuring units as claimed in Claim 1 to 8, **characterized in that**
their supports (1), support bodies (3) and pressure sensors (5) are prefabricated,
wherein multiple support bodies (3) are simultaneously made from an initial material of the support bodies (3) that is available in the form of a foil or disk, wherein the first trenches (21) and/or recesses (31) are produced in the individual support bodies (3) using a machining process and the support bodies (3) are then separated using a separation procedure, and
pressure measuring devices are made from the prefabricated components, wherein their support bodies (3) are mounted on their supports (1) by means of a joining procedure implemented by means of a joining procedure using a joining material and their pressure sensors (5) are mounted on their support bodies (3) by means of a joining procedure implemented by means of a joining material, wherein the joints are implemented in such a way that the joint surface (29, 33) arranged on the front face of the support body (3) facing towards the support (1) is greater than or equal to the joint surface (23) arranged on the front face of the support body (3) facing towards the pressure sensor (5).

10. Procedure as claimed in Claim 9, **characterized in that** at least a machining procedure and/or the separation procedure is a procedure performed using a cutting tool that works with laser or ultrasound, or using a saw.

11. Procedure as claimed in Claim 9 to 10 to produce pressure measuring devices as claimed in Claim 9, **characterized in that** the trenches (35) containing the trench segments (37) forming the first trenches (21) arranged on the front face of the support bodies (3) facing towards the pressure sensor (5) and/or the trenches (35) containing the trench segments (37) forming the second trenches (27) arranged on the front face of the support bodies (3) facing towards the support (1) are each produced by saw cuts introduced in the initial material by a saw, wherein said cuts extend from an outside of the initial material to an outside of the initial material opposite this.

12. Procedure as claimed in Claim 9 to 11 to produce pressure measuring devices as claimed in Claim 5, **characterized in that** the recesses (31) are produced by saw cuts introduced in the initial material by a saw, wherein said cuts extend from an outside of the initial material to an outside of the initial material opposite this.

13. Procedure as claimed in Claim 9 to 12, **characterized in that** each pressure measuring device is made in such a way that, during the joining procedure used to produce the first joint (17), any excess joining material leaving, to the outside, a gap existing between the joint surface (23) of the support body (3) and a surface of the pressure sensor (5) opposite this is collected by the first trench (21) surrounding the joint surface (23).

14. Procedure as claimed in Claim 9 to 13 to produce pressure measuring devices whose support bodies (3) have the second trench (27) or the recess (31) on the front face facing towards the support (1),
**characterized in that** each pressure measuring device is made in such a way that, during the joining procedure used to produce the second joint (19), any excess joining material leaving, to the outside, a gap existing between the joint surface (29) of the support body (3) and a surface of the support (1) opposite this is collected by the second trench (27) surrounding the joint surface (29) or by the recess (31) surrounding the joint surface (29).

15. Procedure as claimed in Claim 9 and pressure measuring device as claimed in Claim 4, **characterized in that** multiple support bodies (3) are made in parallel from an initial material of the support bodies (3) which is in the shape of a foil or disk such that the first trenches (21), the second trenches (27) and/or the recesses (31) are each made in the individual support bodies (3) using the machining procedure and the support bodies (3) are subsequently separated using the separation procedure.

## Revendications

1. Dispositif de mesure de pression, avec
un support (1),
un corps d'appui (3) disposé sur le support (1),
un capteur de pression (5) disposé sur le corps d'appui (3),
un premier joint (17) reliant le corps d'appui (3) au capteur de pression (5) et comprenant un matériau d'assemblage, et
un deuxième joint (19) reliant le corps d'appui (3) au support (1) et comprenant un matériau d'assemblage,
le corps d'appui (3) présentant, sur sa face frontale tournée vers le capteur de pression (5), une première tranchée (21) qui est réalisée de telle sorte que
la première tranchée (21) entoure de tous côtés, sur le côté extérieur, une face de joint (23) du corps d'appui (3) tournée vers le capteur de pression (5),
la face de joint (23) du corps d'appui (3) et une surface de base du premier joint (17) sont sensiblement de même taille et réellement plus petites qu'une surface de base du capteur de pression (5) tournée vers le premier joint (17), et
la première tranchée (21) présente une largeur (b) qui est supérieure ou égale à une largeur minimale de 150 µm à 1 mm, et
la première tranchée (21) présente une profondeur (t) qui est supérieure ou égale à une profondeur minimale de 0,3 mm à 2 mm, et
**caractérisé en ce que**
la surface de joint (29, 33) disposée sur la face frontale du corps d'appui (3) orientée vers le support (1) est supérieure ou égale à la surface de joint (23) disposée sur la face frontale du corps d'appui (3) orientée vers le capteur de pression (5).

2. Dispositif de mesure de pression selon la revendication 1, **caractérisé**
**en ce qu'**un espace intermédiaire (25) disposé entre une surface du corps d'appui (3) entourant extérieurement la première tranchée (21) et la surface du capteur de pression (5) opposée à celle-ci forme un espace creux qui est exempt de matériau d'assemblage,
**en ce que** le corps d'appui (3) présente une surface de base qui est supérieure ou égale à une surface de base d'une face frontale du capteur de pression (5) tournée vers le premier joint (17), et/ou
**en ce que** le premier joint (17) et/ou le deuxième joint (19) sont réalisés chacun sous forme de brasage de verre, de brasage tendre ou de collage.

3. Dispositif de mesure de pression selon l'une des revendications 1 à 2, **caractérisé en ce que**
le capteur de pression (5) présente une surface de base de l'ordre de 1 mm² à 50 mm²,
la face de joint (23) du corps d'appui (3) tournée vers le capteur de pression (5) présente une taille de 0,2 mm² à 20 mm²,
le support (1) est constitué d'un métal ou d'un acier inoxydable,
le corps d'appui (3) est constitué d'un métal, d'un acier inoxydable, de kovar, d'invar, d'une céramique, d'oxyde d'aluminium (Al₂O₃), de carbure de silicium (SiC), de nitrure de silicium (Si₃N₄), de nitrure d'aluminium (AIN), de verre, de verre de borosilicate ou d'un matériau comprenant du silicium,
le corps d'appui (3) est conçu comme un corps essentiellement en forme de disque avec une surface de base circulaire, rectangulaire ou carrée, et/ou
le corps d'appui (3) est disposé comme élément indépendant directement sur le support (1) ou est inséré comme élément indépendant dans un évidement (39) dans le support (1), et/ou le corps d'appui (3) présente une hauteur de construction (H) supérieure ou égale à 1 mm, la hauteur de construction (H) étant en même temps supérieure ou égale à deux fois la profondeur (t) de la première tranchée (21).

4. Dispositif de mesure de pression selon l'une des revendications 1 à 3, **caractérisé en ce que** le corps d'appui (3) présente, sur sa face frontale tournée vers le support (1), une deuxième tranchée (27) qui entoure de tous côtés, côté extérieur, une face de joint (29) du corps d'appui (3) tournée vers le support (1),
le deuxième joint (19) présente une surface de base, qui est sensiblement égale à la face de joint (29) entourée par la deuxième tranchée (27),
la deuxième tranchée (27) présente une largeur (b) qui est supérieure ou égale à une largeur minimale de 150 µm à 1 mm, et
la deuxième tranchée (27) présente une profondeur (t) qui est supérieure ou égale à une profondeur minimale de 0,3 mm à 2 mm.

5. Dispositif de mesure de pression selon l'une des revendications 1 à 3, **caractérisé en ce que** le corps d'appui (3) présente sur sa face frontale tournée vers le support (1) un évidement (31) périphérique extérieur, ouvert vers une surface d'enveloppe extérieure et vers la face frontale du corps d'appui (3) tournée vers le support (1),
lequel évidement entoure de tous côtés, côté extérieur, la face de joint (33) du corps d'appui (3) tournée vers le support (1), et
évidement dont la hauteur (h1) est supérieure ou égale à une hauteur minimale de 0,3 mm à 2 mm, et/ou dont la largeur (b1) est supérieure ou égale à une largeur minimale de 150 µm à 1 mm.

6. Dispositif de mesure de pression selon l'une des revendications 1 à 5, **caractérisé en ce que** la tranchée (21) disposée sur la face frontale du corps d'appui (3) tournée vers le capteur de pression (5) et/ou la deuxième tranchée (27) disposée sur la face frontale du corps d'appui (3) tournée vers le support (1) sont réalisées chacune sous la forme d'une tranchée (21, 27) fermée en anneau.

7. Dispositif de mesure de pression selon l'une des revendications 1 à 6, **caractérisé en ce que** le premier joint (17) et/ou le deuxième joint (19) est respectivement conçu comme un collage.

8. Dispositif de mesure de pression selon l'une des revendications 1 à 7, **caractérisé en ce que**
le corps d'appui (3) présente, sur sa face frontale tournée vers le capteur de pression (5), quatre tranchées (35) pratiquées dans le corps d'appui (3) et s'étendant chacune en ligne droite d'un côté extérieur du corps d'appui (3) à un côté extérieur du corps d'appui (3) opposé à ce côté extérieur, lesquelles tranchées présentent chacune un segment de tranchée (37) s'étendant parallèlement à l'un des bords extérieurs de la face de joint (23) et directement adjacent au bord extérieur respectif, et lesquelles tranchées sont disposées de telle sorte que les quatre segments de tranchée (37) adjacents aux bords extérieurs de la face de joint (23) forment la première tranchée (21) entourant la face de joint (23) de tous côtés sur le côté extérieur, et/ou
le corps d'appui (3) présente, sur sa face frontale tournée vers le support (1), quatre tranchées (35) pratiquées dans le corps d'appui (3) et s'étendant chacune en ligne droite d'un côté extérieur du corps d'appui (3) à un côté extérieur du corps d'appui (3) opposé à ce côté extérieur, lesquelles tranchées présentent chacune un segment de tranchée (37) s'étendant parallèlement à l'un des bords extérieurs de la face de joint (29) et directement adjacent au bord extérieur respectif, et lesquelles tranchées sont disposées de telle sorte que les quatre segments de tranchée (37) adjacents aux bords extérieurs de la face de joint (29) forment la deuxième tranchée (27) entourant la face de joint (29) de tous côtés sur le côté extérieur.

9. Procédé destiné à la fabrication de dispositifs de mesure de pression selon les revendications 1 à 8, **caractérisé en ce que**
leur support (1), leurs corps d'appui (3) et leur capteur de pression (5) sont préfabriqués,
plusieurs corps d'appui (3) étant fabriqués parallèlement les uns aux autres à partir d'un matériau de départ des corps d'appui (3) se présentant sous la forme d'une feuille ou d'un disque, **en ce que** les premières tranchées (21) et/ou les évidements (31) dans les différents corps d'appui (3) sont réalisés respectivement au moyen d'un procédé d'usinage et les corps d'appui (3) sont ensuite séparés au moyen d'un procédé de séparation, et
des dispositifs de mesure de pression sont fabriqués à partir des composants préfabriqués, leurs corps d'appui (3) étant montés sur leur support (1) au moyen d'un procédé d'assemblage réalisé au moyen d'un matériau d'assemblage et leur capteur de pression (5) étant monté sur leur corps d'appui (3) au moyen d'un procédé d'assemblage réalisé au moyen d'un matériau d'assemblage, les assemblages étant réalisés de telle sorte que la face de joint (29, 33) disposée sur la face frontale du corps d'appui (3) tournée vers le support (1) devient plus grande que la face de joint (23) disposée sur la face frontale du corps d'appui (3) tournée vers le capteur de pression (5).

10. Procédé selon la revendication 9, **caractérisé en ce qu'**au moins un procédé d'usinage et/ou le procédé de séparation est un procédé exécuté au moyen d'un outil de coupe fonctionnant au laser ou aux ultrasons, ou au moyen d'une scie.

11. Procédé selon l'une des revendications 9 à 10 destiné à la fabrication de dispositifs de mesure de pression selon la revendication 9, **caractérisé en ce que** les tranchées (35) contenant les segments de tranchée (37) formant les premières tranchées (21) disposées sur la face frontale des corps d'appui (3) tournée vers le capteur de pression (5) et/ou les tranchées (35) contenant les segments de tranchée (37) formant les deuxièmes tranchées (27) disposées sur la face frontale des corps d'appui (3) tournée vers le support (1) sont respectivement produites par des coupes de scie réalisées dans le matériau de départ au moyen d'une scie, qui s'étendent d'un côté extérieur du matériau de départ jusqu'à un côté extérieur du matériau de départ opposé à celui-ci.

12. Procédé selon l'une des revendications 9 à 11 destiné à la fabrication de dispositifs de mesure de pression selon la revendication 5, **caractérisé en ce que** les évidements (31) sont créés par des coupes de scie réalisées dans le matériau de départ au moyen d'une scie, lesquels évidements s'étendent d'une face extérieure du matériau de départ jusqu'à une face extérieure du matériau de départ opposée à celle-ci.

13. Procédé selon l'une des revendications 9 à 12, **caractérisé en ce que** chaque dispositif de mesure de pression est fabriqué de telle sorte que, pendant le procédé d'assemblage utilisé pour produire le premier joint (17), le matériau d'assemblage excédentaire sortant éventuellement d'un interstice existant entre la face de joint (23) du corps d'appui (3) et une surface du capteur de pression (5) opposée à celle-ci, est recueilli sur le côté extérieur par la première tranchée (21) entourant la face de joint (23).

14. Procédé selon l'une des revendications 9 à 13 destiné à la fabrication de dispositifs de mesure de pression, dont le corps d'appui (3) présente sur sa face frontale tournée vers le support (1) la deuxième tranchée (27) ou l'évidement (31), **caractérisé en ce que** chaque dispositif de mesure de pression est fabriqué respectivement de telle manière que, pendant le procédé d'assemblage utilisé pour produire le deuxième joint (19), le matériau d'assemblage excédentaire sortant éventuellement, côté extérieur, d'un interstice existant entre la face de joint (29) du corps d'appui (3) et une surface du support (1) opposée à celle-ci est recueilli par la deuxième tranchée (27) entourant la face de joint (29) ou par l'évidement (31) entourant la face de joint (29).

15. Procédé selon la revendication 9 et dispositif de mesure de pression selon la revendication 4, **caractérisé en ce que** plusieurs corps d'appui (3) sont fabriqués parallèlement les uns aux autres à partir d'un matériau de départ des corps d'appui (3) se présentant sous la forme d'une feuille ou d'un disque, en produisant les premières tranchées (21), les deuxièmes tranchées (27) et/ou les évidements (31) dans les différents corps d'appui (3) respectivement au moyen du procédé d'usinage et en séparant ensuite les corps d'appui (3) au moyen du procédé de séparation.
